# EUROPEAN PATENT SPECIFICATION

(11) **EP 4 579 756 B1**
(45) Date of publication and mention of the grant of the patent: **04.11.2026**
(21) Application number: 24188976.5
(22) Date of filing: 16.07.2024
(51) Int. Cl.: H10D 64/27, H10D 48/00, H10D 62/81, H10D 62/10, B82Y 10/00

(54) **STRESSOR DEFINED SEMICONDUCTOR QUANTUM DEVICE**
STRESSORDEFINIERTE HALBLEITERQUANTENVORRICHTUNG
DISPOSITIF QUANTIQUE À SEMI-CONDUCTEUR DÉFINI PAR UN STRESSEUR

(30) Priority: 28.12.2023 EP 23220560
(43) Date of publication of application: 02.07.2025
(73) Proprietor: IHP GmbH - Leibniz Institute for High Performance Microelectronics/ Leibniz-Institut für innovative Mikroelektronik, 15236 Frankfurt (Oder) (DE)
(72) Inventor: Zöllner, Marvin, 15236 Frankfurt (Oder) (DE); Virgilio, Michele, 15236 Frankfurt (Oder) (DE); Reichmann, Felix, 15236 Frankfurt (Oder) (DE); Manganelli, Costanza, 15236 Frankfurt (Oder) (DE); Corley-Wiciak, Cedric, 15236 Frankfurt (Oder) (DE); Capellini, Giovanni, 15236 Frankfurt (Oder) (DE)
(74) Representative: Eisenführ Speiser

(56) References cited:
- WO-A1-2008/038346
- WO-A1-2018/057013
- WO-A1-2018/063202
- BENJAMIN D WOODS ET AL: "Coupling conduction-band valleys in modulated SiGe heterostructures via shear strain", ARXIV.ORG, CORNELL UNIVERSITY LIBRARY, 201 OLIN LIBRARY CORNELL UNIVERSITY ITHACA, NY 14853, 29 October 2023 (2023-10-29), XP091647211
- MATTHIAS K\"UNNE ET AL: "The SpinBus Architecture: Scaling Spin Qubits with Electron Shuttling", ARXIV.ORG, CORNELL UNIVERSITY LIBRARY, 201 OLIN LIBRARY CORNELL UNIVERSITY ITHACA, NY 14853, 28 June 2023 (2023-06-28), XP091549565

## Description

### FIELD OF THE INVENTION

The present invention is in the field of quantum computing devices, and in particular relates to a semiconductor component for use in the storing, transporting and processing of quantum states.

### BACKGROUND

In computing applications, including digital communication technology, the concept of a bit represents an elementary unit of information. A bit describes a logical state. At a given point in time a bit can assume only one of exactly two possible values. The two possible logical states are typically represented by binary digits, 0 or 1. This can be implemented technically e.g. by a charge storage device that can be written to by charging or discharging it in order to represent one of the two logical states, which can be read e.g. by measuring a voltage across the charge storage device.

In contrast, a qubit is a quantum-mechanical system having states that are associated with different energy levels. The state of a qubit can be described as a coherent superposition of its states. As such, one qubit allows encoding more information than one bit. However, while reading a bit does not disturb its state, the coherent superposition of states in the quantum-mechanical system of a qubit may be disturbed by a measurement operation required for reading the stored information. Technical implementations of a qubit include quantum-mechanical multi-level spin systems associated with particles. For instance, under certain conditions to be discussed further below, the spin state of a single electron may form a quantum-mechanical two-level system, spin up or spin down. Spin qubits can be realized within a quantum dot. A quantum dot provides an island-like "0D" confinement potential that can house one single electron, which stores the quantum information. Known methods for writing and reading a qubit include for example the exploitation of electron spin resonance (ESR) in electrostatic quantum dots (QDs) under an alternating magnetic field.

Qubit devices that are suitable for commercial application have been proposed in the form of semiconductor components with particular nanoscale semiconductor structures. Exemplary low-dimensional systems formed in such semiconductor structures are based on nanoscale quantum films, which are also known as quantum wells, or mesas, or quantum wires, or, as mentioned, quantum dots. In such structures, a separation of energy levels of charge carriers can be realized by suitable local charge carrier confinement. This charge carrier confinement can be achieved by spatial limitations such as interfaces, e.g. heteroepitaxial interfaces, or surfaces. These effects can be enhanced for applications in quantum computing and photonics, e.g., by adding strain or applying electric potentials. In Si-based quantum wells (QWs) on epitaxial SiGe hetero structures, one approach for the realization of a solid-state based quantum processor are spin qubits housed in electrostatic quantum dots (QDs) with an isotopically purified quantum well, e.g. ²⁸Si enriched.

US 2022/0335322 A1 describes an electronic component for logically connecting qubits of a quantum computer. The component is formed by a semiconductor component. It comprises a substrate made of SiGe with a two dimensional electron gas or electron hole gas and assemblies of gate electrodes, which are arranged on a surface of the electronic structure component. Electrical contacts connect the gate electrode assemblies to voltage sources. The gate electrodes of the gate electrode assemblies have parallel electrode fingers. By suitably applying sinusoidal voltages to the gate electrodes of the gate electrode assembly a movable potential well is generated in the substrate. The potential well is transported longitudinally through the substrate through suitable control of the electrode fingers with sinusoidal voltages. A quantum dot confined in such a potential well is described to be transported with this potential well over a greater distance in the two-dimensional electron gas of the substrate without experiencing a quantum mechanical change of state.

WO 2018/063202 A1 describes quantum dot devices that include a quantum well stack including a barrier layer and a quantum well layer; gates disposed on the quantum well stack such that the barrier layer is disposed between the gates and the quantum well layer; and strain material regions that extend through the barrier layer and into the quantum well layer.

WO 2018/057013 A1 describes quantum dot devices, as well as that include a quantum well stack structure including a base, a first strained layer, and a second strained layer, wherein the first strained layer is disposed between the base and the second strained layer, and the first and second strained layers are oppositely strained; and a plurality of gates disposed on the quantum well stack structure.

The publication BENJAMIN D WOODS ET AL: "Coupling conduction-band valleys in modulated SiGe heterostructures via shear strain", ARXIV.ORG, CORNELL UNIVERSITY LIBRARY, 201 OLIN LIBRARY CORNELL UNIVERSITY ITHACA, NY 14853, 29 October 2023 discusses engineering of conduction-band valley couplings as a key challenge for Si-based spin qubits. A described method for enhancing valley couplings entails adding Ge concentration oscillations to the quantum well. Benefits of short-wavelength oscillations are described to be achieved in long-wavelength structures through a second-order coupling process involving Brillouin-zone folding, induced by shear strain.

WO2008038346 A1 describes a MOSFET device that integrates strained "ladder" structures between the gate and the gate dielectric to induce carrier confinement in the underlying channel layer. The confinement leads to multiple parallel quantum-wire FETs being generated that are controlled via the same gate electrode.

### SUMMARY OF THE INVENTION

The present invention is defined by a semiconductor component according to claim 1. Additional features of some embodiments of the semiconductor component are defined in the dependent claims.

By using the stressor layer for adding a varying lattice strain to the confinement layer in a lateral direction and the stacking direction, an energy difference between at least two conduction band valleys hosting confined charge carrier spin states is achieved, which allows forming quantum dot-based qubits with high reliability, but low processing expenditure. A spatially varying lattice strain into the active layer stack, in particular to the confinement layer, for generating the strain-based second confinement potential component of the total lateral confinement potential profile in the confinement layer, can in particular be achieved in an arrangement of the stressor layer, which includes a patterning of the stressor layer. In such a patterned stressor layer, certain parts of the stressor layer are recessed or completely removed. This way, a desired lateral variation of the lattice strain applied by the stressor layer to the confinement layer can be achieved. According to the present invention, the stressor layer is patterned to comprise a stressor recess structure defining a one-dimensional strain-induced carrier confinement region in the confinement layer. This way, the stressor recess structure creates a first confinement potential component that contributes to or fully achieves a confinement of charge carriers to a lateral region corresponding to a lateral extension that is perpendicular to a longitudinal extension of the one-dimensional stressor recess structure.

In particular embodiments, the stressor recess structure may take the form of a longitudinal stressor trench, with a longitudinal trench extension that is larger than a lateral trench extension which is in a direction perpendicular to the longitudinal trench extension. For the example of silicon, the longitudinal trench extension is for instance parallel to the [110] directions.

Instead of a longitudinal rectangular trench, other trench patterns in the stressor layer can be used to achieve a desired confinement of charge carriers. For instance, the stressor layer may comprise a pattern of openings, of which in a plan view each may take the form of a circle, oval, square or a ring circumscribing any of these shapes. The patterning of the stressor layer may also be used to provide accommodation for sections of the confinement gate electrodes which extend through the stressor layer.

The structural features of the semiconductor component are particularly suited for an implementation in an industrial CMOS technology.

The structure of the active layer stack may be varied. For instance, it may additionally comprise a capping layer, on which the dielectric layer is deposited.

The arrangement of the confinement gate electrodes may also be varied in different embodiments. The confinement gate electrodes may be arranged on the dielectric layer. However, as an alternative, the confinement gate electrodes may arranged on the stressor layer. A combination of both of these types of arrangements for different confinement gate electrodes in a given semiconductor component may be suitable.

The stressor recess structure may accommodate a device for injecting charge carriers into the confinement layer. As an example, an injection gate electrode may be used.

Further, in a sequence along its longitudinal trench extension, a confinement-electrode group crossing the stressor recess structure in a direction perpendicular to its longitudinal direction may be arranged. The confinement gate electrode group is suitably arranged to generate, under application of suitable respective confinement control voltages to the confinement gate electrodes, an electrostatic confinement potential profile along the longitudinal direction, which enables a carrier accumulation zone and charge carrier depletion zones to form the volume spanning less than two dimensions as a quantum dot volume in the confinement layer underneath the trench and between the outer confinement gate electrodes.

For instance, three confinement gate electrodes may be used, which with regard to the longitudinal direction of the one-dimensional stressor recess structure comprises two outer confinement gate electrodes and a central confinement gate electrode there between. While three confinement gate electrodes per confinement-electrode group are preferred, any of the confinement-electrode groups provided may comprise two confinement gate electrodes only, or more than three two confinement gate electrodes.

In particular for storage and processing device applications, the semiconductor component typically comprises a plurality of the confinement gate electrode groups along the longitudinal direction, to form a corresponding plurality of quantum dot volumes in the confinement layer.

To increase the density of qubits, the semiconductor component may comprise two or more parallel longitudinal stressor trenches, each having one or more injection device and at least one confinement gate electrode group along its longitudinal extension. Coupling between pairs of qubits may be achieved in this arrangement by further arranging a longitudinal coupling trench in the stressor layer in parallel to, as well as between, a pair of parallel longitudinal stressor trenches, wherein the longitudinal coupling trench accommodates a coupling electrode with a longitudinal extension corresponding to that of all confinement gate electrode groups. The coupling electrode is arranged and configured to establish, upon application of a suitable coupling voltage, an interaction between confined charge carriers of qubit pairs in quantum dots that are arranged mutually opposite on both sides of the coupling electrode.

Furthermore, the semiconductor component may comprise a matrix arrangement with matrix rows and matrix columns of quantum dots. The quantum dots in the same row and belonging to adjacent columns may be coupled through a coupling electrode that is interposed between the adjacent columns. The interposed coupling electrode may comprise independent longitudinal sections so as to address different dots in the same column separately. Two respective quantum dots on opposite sides of a coupling electrode in a matrix row may house a respective qubit pair. The stressor layer is further patterned to accommodate a group of shuttling electrodes, each extending perpendicularly to the longitudinal extension along the matrix columns between two neighboring matrix rows, to interconnect, by application of a respective electrostatic shuttling potential, the qubits of the neighboring matrix rows by interdot tunnel coupling.

This way, a transport of the qubits along the longitudinal trench direction may be achieved. The distance of charge carrier transport can be influenced by a desired number of repetitions of the group of shuttling electrodes in the longitudinal direction. In these embodiments, the presence of the stressor layer enhances the carrier confinement, thus reduces the effect of perturbations and improves the stability of a quantum state during qubit transport.

Suitably, the electrostatic shuttling potential is selected to be of a sinusoidal shape in the confinement layer. The shuttling electrodes, which are suitably embedded in dielectric material may be arranged at different distances from the confinement layer. Seen in a plan view, shuttling electrodes at different distances from the confinement layer may laterally overlap each other. This allows achieving a particularly smooth shuttling potential profile.

The semiconductor component may advantageously be built using CMOS-compatible materials. In particular, the active layer stack may be single layers or sequences of Si, Ge or SiGe, such as for example SiGe/Si or SiGe/Si/SiGe.

The stressor layer may be made of SiNx, TiNx, AlNx, SiOx, Si, Ge, or Si₁₋ₓGeₓ (in a stoichiometric composition that is suitable to generate desired strain). It is noted that an active stressor layer may be used, which by means of controlling the amplitude of a piezo effect can generate tunable lattice strain in the confinement layer. The stressor layer may comprise a plurality of layers. The gate electrodes may be made of metals or semimetals such as Pd, Rh, TiN or poly-silicon.

In the following, exemplary embodiments will be described with reference to the enclosed drawings.

### BRIEF DESCRIPTION OF THE DRAWINGS

Fig. 1 shows an illustration of a processed Si/Si_{0.7}Ge_{0.3} hetero structure for an electron spin qubit with an oxide dielectric, gate electrodes and a two-Dimensional Electron Gas (2DEG) and serves as background for the present invention.
Fig. 2 is a diagram of the energy levels of the Si conduction band and valley splittings for the device structure in Fig. 1.
Fig. 3 is a plan view of an exemplary patterned stressor layer on a hetero structure of a semiconductor component, according to the invention;
Fig. 4 is a cross-sectional view of along the line IV-IV in Fig. 3;
Figs. 5 to 8 show exemplary COMSOL simulations, for devices according to the invention. The exemplary normal ε_{zz} strain component is shown in Fig. 5 while the influence on the Δ₂ conduction band edge minimum (Fig. 6) was simulated considering all diagonal strain components εₓₓ, ε_{yy} and ε_{zz}. Fig. 7 and 8 show, exemplarily, the off-diagonal ε_{xy} component and the strain gradient δε_{zz}/δz, which may be crucial in breaking the symmetry of the crystal unit cell and, therefore, inducing valley splitting.
Figs. 9 to 12 are different views of another semiconductor component, according to the invention, based on a general structure of the semiconductor component illustrated in Fig. 9, followed by a more detailed plan view in Fig 10 and cross-sectional views in Figs. 11 and 12 along the lines XI-XI and XII-XII shown in Fig. 10, respectively.
Figs. 13 and 14 are plan views of a further semiconductor component, according to the invention, wherein Fig. 14 shows an exemplary design based on the general structure of the semiconductor component of Fig. 13.
Figs. 15 and 16 are plan views of a further semiconductor component, according to the invention, wherein Fig. 16 shows an exemplary design based on the general structure of the semiconductor component of Fig. 16.
Figs. 17 and 18 are plan views of a further semiconductor component, according to the invention, wherein Fig. 18 shows an exemplary design based on the general structure of the semiconductor component of Fig. 17.

### DETAILED DESCRIPTION OF EMBODIMENTS

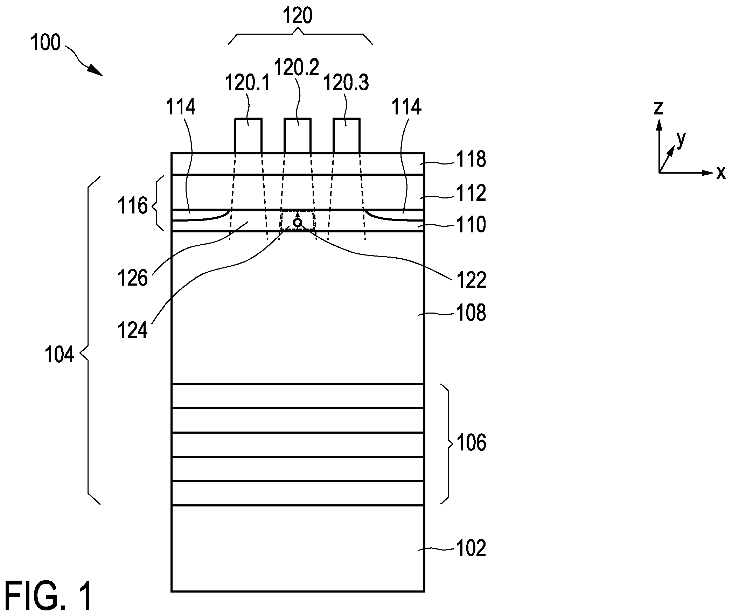

Fig. 1 shows an illustration of an exemplary semiconductor-based device or processed semiconductor component 100, which comprises, on a substrate 102, semiconductor hetero structure 104 for an electron spin qubit. The semiconductor hetero structure 104 comprises a compositionally graded transition layer 106 on the silicon substrate 102. The transition layer 106 is generally made of SiGe and exhibits a compositional grading of its Ge content, which increases with the distance from the substrate 102. The stoichiometry of the SiGe transition layer 106, expressed in relative numbers between 0 and 1 that add up to 1, starts with a Ge content of 0.0 and a silicon content of 1.0 at an interface to the substrate 102 and reaches a Ge fraction of 0.3 and a Si fraction of 0.7 at an interface to a buffer layer 108. In Fig. 1, the compositional grading is illustrated by a stepwise increase in the Ge content over 5 sublayers of the transition layer 106. However, it is noted that this compositional grading profile an exemplary structure only, and other implementations of the transition layer with more or less steps in Ge fraction, or with a continuous Ge composition grading, or even a backwards grading may be used, as is per se known in the art. Also, the upper limit of the compositional grading of 0.3 is an exemplary value that may be selected differently. However, it should approximately match the stoichiometry of the buffer layer 108. The transition layer 106 has a typical thickness of more than 2 micrometer and preferably less than 5 micrometer. On the transition layer 106, the buffer layer 108 is deposited with the stoichiometry reached by the transition layer 106. In the present case, thus, the buffer layer 108 is made of Si_{0.7}Ge_{0.3}. However, the Ge content may be somewhat higher or lower, in any case sufficient to exert a desired lattice strain on the following confinement layer 110 that forms a quantum well. The buffer layer 108 has a typical thickness of more than 2 micrometer and preferably less than 5 micrometer.

On the buffer layer, an active layer stack 116 is deposited. The active layer stack 116 comprises a confinement layer 110 made of silicon. In other variants, the confinement layer 110 may have a concentration profile or alloying of SiGe. The confinement layer 110 has a thickness between 3nm and 30nm, in some examples about 7 nanometer, and it exhibits heteroepitaxial tensile lattice strain, which is imposed by the underlying Si_{0.3}Ge_{0.7} buffer layer in the active layer stack 116. A Si_{0.7}Ge_{0.3} barrier layer 112 is deposited on top of the confinement layer 110 in the active layer stack 116 and has a thickness of between 10nm and 200nm, in some examples approximately 35 nanometer. This arrangement enables the realization of a two-dimensional electron gas 114 (herein also referred to in short as 2DEG) at the interface of the Si confinement layer 110 with the Si_{0.7}Ge_{0.3} barrier layer 112. Thus, the Si confinement layer 110 has the function of a confinement layer for establishing a quantum confinement of charge carriers to not more than two-dimensions in the confinement layer, i.e., the Si confinement layer 110. Other confinement structures, which are per se known in the art, may be used. The active layer stack 116 may further comprise a capping layer (not shown) on the barrier layer 112.

A dielectric layer 118 is deposited on top of the barrier layer 112 (or on the capping layer). The dielectric layer may be made of silicon dioxide and have a thickness of between 3 and 30 nm, in some examples about 7 nanometer. A group of confinement gate electrodes 120, in the present example three confinement gate electrodes 120.1, 120.2, and 120.3, are arranged on the dielectric layer 118. A confinement control unit configured to generate and provide the respective electrical confinement control voltages to the confinement gate electrodes may be provided either on-chip or off-chip and is not shown in Fig. 1.

It is noted that a similar confinement of charge carriers can be achieved by growth or patterning the material in one-dimensional (1D) or zero-dimensional (0D) shape, realized e.g. by nanowires or FinFETs. This is per se known in the art.

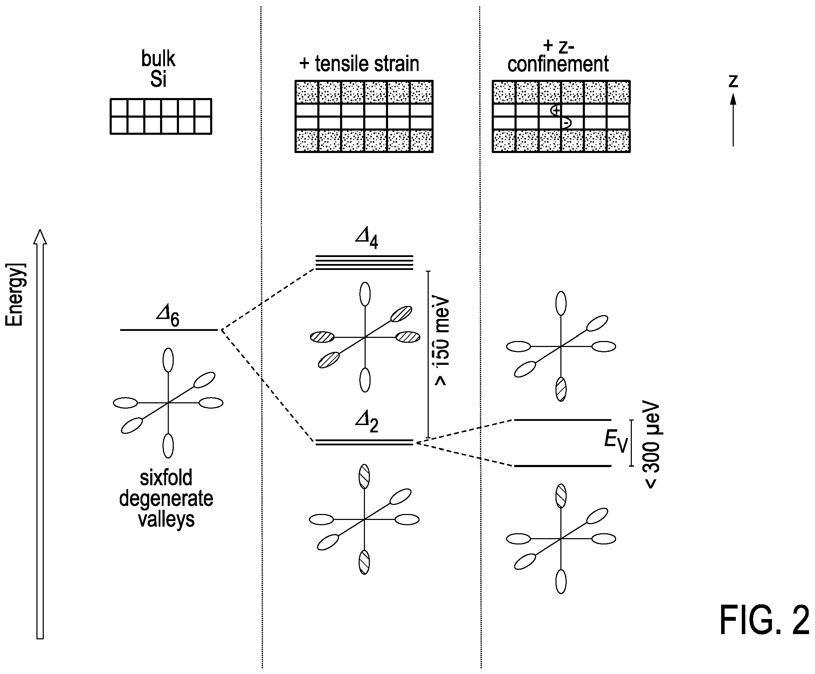

Fig. 2 is a diagram of the energy levels of the Si conduction band and the formation of a conduction band valley splitting for the device structure in Fig. 1. The illustration has two rows and three columns. In the upper row, left column, a bulk silicon lattice is illustrated schematically as group of squares attached to each other in two rows, representing bulk silicon lattice cells. In this bulk silicon lattice, as illustrated in the second row of the left column, the conduction band valley has a sixfold degeneracy. In other words, electrons at the conduction minimum assume one of six different states which all have the same energy level.

This sixfold degeneracy is partly lifted, as illustrated in the middle column, by a tensile biaxial lattice strain exerted by the buffer layer 108. The tensile lattice strain is represented in the upper row of the middle column of Fig. 2 as a distortion of the bulk silicon lattice cells, which are represented by rectangles rather than squares to illustrate tensile biaxial strain in the plane that extends perpendicularly to a stacking direction z of the active layer stack 116. The biaxial strain in the typical Si QW layer 110 is ε_{∥} ≈ 1.2 % and the corresponding splitting EΔ₄ - EΔ₂ amounts to approximately 200 meV.

Thus, the biaxial tensile strain leads to a split of the conduction band minimum into two energy levels, namely, a higher-energy, fourfold degenerate level and a lower-energy, two-fold degenerate level. As shown in the right column of Fig. 2, the two-fold degeneracy of the lower energy level is lifted by an additional application of a confinement potential that restrains the location of charge carriers injected into the confinement layer 110 in the stacking direction z, as explained with reference to Fig. 1. Thus, the electrons in the Si quantum well (QW) layer 110 are confined in the vertical direction by the interface to the barrier layer 112 and buffer layer 108 realized by band energy offset between the strained Si layer 110 and SiGe layer 112 as well as the buffer layer 108 to form a two dimensional electron gas (2DEG). The splitting Eᵥ between the two Δ₂ states (± z valleys) is achieved by the confinement of the electron wave function by the Si/Si₁₋ₓGeₓ interfaces, which couples the two valleys. In typical Si/SiGe quantum hetero structures, valley splittings show a spread ranging approximately between 0 and 300 µeV. By applying voltages to the gate electrodes 120, which may be fabricated by lithography on top of the dielectric layer 118, electrostatic quantum dots 124 may be formed by creating a pattern of accumulation zones 114 and depletion zones 126 of charge carriers within the confinement layer 110. Thus, an electron 122 can be confined along all three spatial directions in such an electrostatic quantum dot 124. In this type of qubit, quantum information is encoded by the single electron 122 loaded into the QD from the 2DEG assuming a spin up or spin down state, or a superposition. The spin manipulation of the spin quantum information can be changed by devices known in the art, e.g. ESR or EDSR.

Thus, the sixfold degeneracy of the silicon conduction band minimum ("valleys") initially provides a degree of freedom that competes with the spin states which encode qubit information. This leads to decoherence, thus possibly violating the third criterion of Loss and DiVincenzo for a functional qubit, which requires long relevant decoherence times. This issue is partially alleviated by a design of the hetero structure, in which the Si QW layer 110 is under tensile biaxial strain from the lattice mismatch between the Si QW layer 110 and SiGe strain relaxed buffer 108. Due to the strain, the sixfold valley degeneracy of the Si conduction band minimum is reduced to a twofold degeneracy. Since the applied strain is tensile, the potential levels of the two out-of-plane valleys Δ₂ are shifted towards lower energies, while the four in-plane valleys Δ₄ are shifted towards higher energy. A splitting Eᵥ between the two Δ₂ states (± z valleys) is achieved by the confinement of the electron wave function by the Si/Si₁₋ₓGeₓ interfaces.

However, this approach faces challenges. As mentioned, epitaxial hetero structures for housing of electron spin qubits grown on Si(001) substrates incorporate a several µm thick Si₁₋ₓGeₓ strain relaxed buffer (SRB, typically x = 0.3), a less than 10 nm thick pseudomor-phic Si QW layer, a Si₁₋ₓGeₓ barrier of a few ten nm thickness, and an optional sacrificial Si cap less than 3 nm thick. Local structural defects induced by strain relaxation, in particular dislocations, are accompanied by spatial fluctuations of lattice strain, which may affect quantum properties such as the QD charging energies, Rabi frequencies, and the gyromagnetic-tensor.

Moreover, shear strain has been shown to affect the nuclear electric resonance and the quadrupole interaction of a coherently controlled nuclear spin in quantum MOS devices. Additionally, these strain fluctuations lead to interface roughening, in particular cross-hatch pattern. The limited sharpness of the non-ideal interfaces in real hetero structures alters the valley splitting. Additionally, the gate electrodes induce local lattice strain in the Si QW layer as well, which may induce the formation of unintentional ("parasitic") QDs. Concluding, for large arrays of QDs, these effects may deteriorate the uniformity and pose an obstacle to a shared gate control.

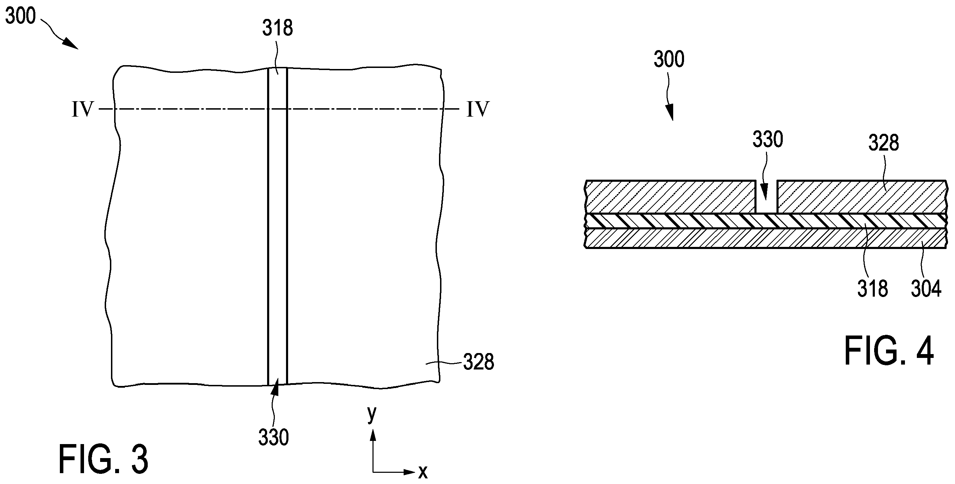

The present invention proposes using an additional layer applying stress (stressor layer) in the context of a family of microelectronic devices, especially but not exclusively for electron and hole spin devices applicable for quantum computing, e.g. single electron transistors (SET), quantum dots (qudot), quantum bits (qubit), transport channels. As will be shown with reference to the embodiments of Figs. 3 to 18, but is not illustrated in Fig. 1, a stressor layer is provided in addition to the layers shown in Fig. 1. With reference to the layer structure of Fig. 1, the stressor layer may be arranged in different positions, in particular:
- below the dielectric layer 118, in particular between the barrier layer 112 and the dielectric layer 118, and/or
- on top of the dielectric layer 118, in particular between the dielectric layer 118 and the confinement gate electrodes 120, and/or
- embedded in the dielectric layer 118. In this case, the layer structure of the dielectric layer 118 and the stressor layer may have a total thickness that is larger than 10 nanometer.

While the examples shown below in the context of Figs. 3 to 18 will be limited to the case of a stressor layer on top of the dielectric layer 118, this is not intended to limit the scope of the possible arrangements. The stressor layer is arranged and configured to apply additional, spatially varying lattice strain to the active layer stack 116, in particular to the confinement layer, for generating a stress-based second confinement potential component of the total lateral confinement potential profile in the confinement layer. The stressor layer may be between 5nm and 500nm thick.

In particular, the stressor layer is patterned to create or support a lower dimensional confinement with distinct energy levels as described above. For instance, a 2D quantum well (QW) is proposed in which the local strain and respectively the local potential landscape is shaped in such a way that lateral quantum confinement and energy level separation can be achieved or supported by the confinement gate electrodes. The synergy achieved with the provision of the confinement gate electrodes and the stressor layer plays a crucial role.

While electrodes applying unintentional strain are already described in prior art, here, the patterned stressor is decoupled from the electrode. In other words, the contribution of the patterned stressor layer, which achieves the strain-based second confinement potential profile component, on the confinement of charge carriers, is independent from the contribution of the electrical confinement gate electrodes, which generate the first electrostatic confinement potential profile component via an applied confinement control voltage. This independence achieves the following benefits:
a) Reduction of required confinement gate electrodes
   As the potential profile of the QW is already sufficiently or at least partially shaped by the patterned stressor layer, the required electrostatic potential at a confinement gate electrode, or even the required number of confinement gate electrodes may be reduced. A reduced number of confinement gate electrodes and/or a reduced confinement control voltage will require less contacts and wiring on the chip, as well as it will generate less heat dissipation, which are critical issues for future quantum processors. Moreover, this also reduces the amount of control voltages that have to be determined to operate each individual device, simplifying shared gate control.
b) Reduction of the required strain from the buffer layer below the QW layer
   As the stress from the stressor layer causes local strain variations within the confinement layer 110, the strain caused by lattice-mismatch between the pseudomorphically grown confinement layer 110 and the strain relaxed buffer layer 108 can be reduced. Therefore, in some embodiments, instead of the combination of a transition layer 106 and the strain relaxed buffer layer 108, only a pseudomophic buffer barrier layer grown on the substrate is arranged underneath the confinement layer 110. In any case, a reduction of the plastic strain relaxation will lead to less threading dislocation density, less random local strain fluctuations and less roughness, which is associated to the formation of a cross-hatch pattern.
c) Improvement the valley splitting within the QW layer

The potential for an increase of the valley splitting is twofold. Firstly, by achieving reduced interface roughness, cf. b) above, the conduction band valley splitting may be increased and local fluctuations of the valley splitting may be reduced. Secondly, the patterned stressor layer may be arranged and configured to achieve that the strain field varies not only laterally but in addition also vertically. The resulting shear strain component as well as strain gradient cause a symmetry break within the QW which may result in an increase of the valley splitting.

The following description of Figs. 3 to 18 turns to different examples of semiconductor components with different stressor layers. The cross-sectional views given in the Figures described below are simplified in that they do not show any detail of the heterostructure, cf. reference label 104 in Fig. 1. For further simplification, the substrate, cf. reference label 102 in Fig. 1, is not shown at all. This is meant to imply that any suitable heterostack and substrate may be used in addition to the stressor layer arrangement given in the respective illustrations. For the purpose of the following description, it may be exemplarily assumed that the heterostack and substrate are as shown in Fig. 1.

An exemplary general structure of patterned stressor is depicted in Figs. 3 and 4, now referred to in parallel. Fig. 3 is a plan view of a stressor layer 328 in an exemplary semiconductor component 300. Fig. 4 is a cross sectional view the semiconductor component 300 along the dashed line IV-IV shown in Fig. 3. The stressor layer 328 is patterned and includes a stressor recess structure in the form of a stressor trench 330, which, as preferred, extends parallel to the crystallographic [110] direction, and is arranged on top of a dielectric layer 318 on a SiGe heterostack 304. The stressor trench 330 extends longitudinally along a direction y in the stressor layer 328. In the present exemplary embodiment, the dielectric layer 318 has a thickness between 3 and 30 nm. The stressor layer 328 is between 5nm and 500nm thick. The stressor trench 330 has a lateral width of between 5nm and 500 nm and as such defines a one-dimensional strain-induced carrier confinement region in the confinement layer

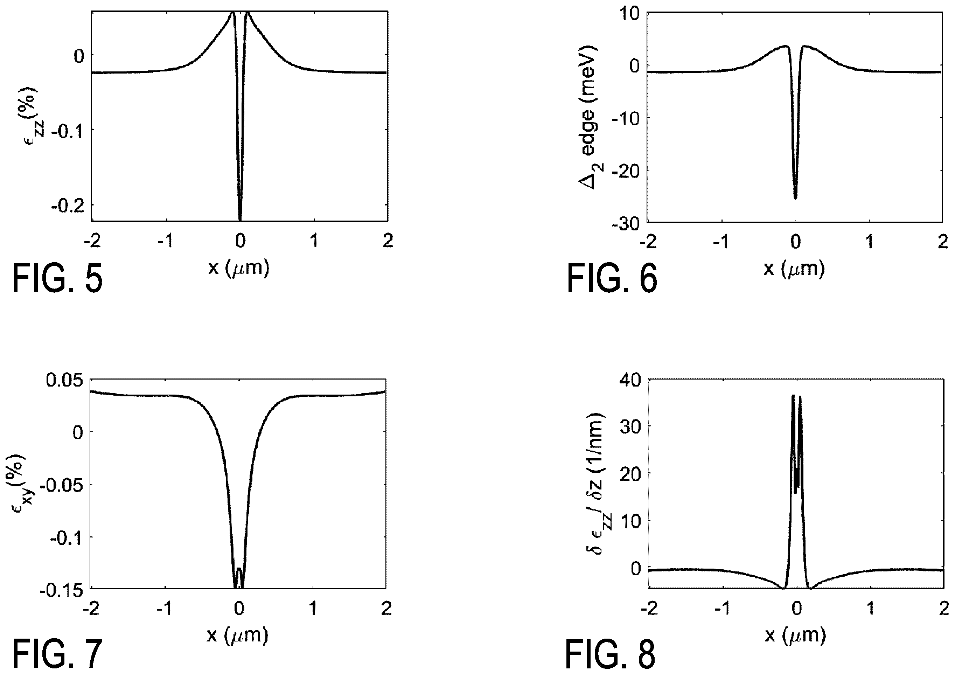

Figs. 5 to 8 show exemplary COMSOL simulations. The exemplary normal ε_{zz} strain component is shown in Fig. 5 while the influence on the Δ₂ conduction band edge mini-mum (Fig. 6) was simulated considering all diagonal strain components εₓₓ, ε_{yy} and ε_{zz}. Fig. 7 and 8 show, exemplarily, the off-diagonal εxy component and the strain gradient δε_{zz}/δz, which may be crucial in breaking the symmetry of the crystal unit cell and, there-fore, inducing valley splitting. Simulations were conducted using the commercial software product COMSOL for a Si QW on a Si_{0.7}Ge_{0.3} buffer and in 50 nm depth (below 40 nm of Si_{0.7}Ge_{0.3} top barrier and 10 nm of SiO2), while a 200 nm thick SiN stressor with a trench width of 40nm imposes -1GPa pressure. The energy minimum in Fig. 6 depicts where a potential confinement of the charge carrier and its quantum state may occur. The depth of the potential well is on the scale of some ten meV, adding a substantial contribution to the lateral confinement helping to reduce gate voltages.

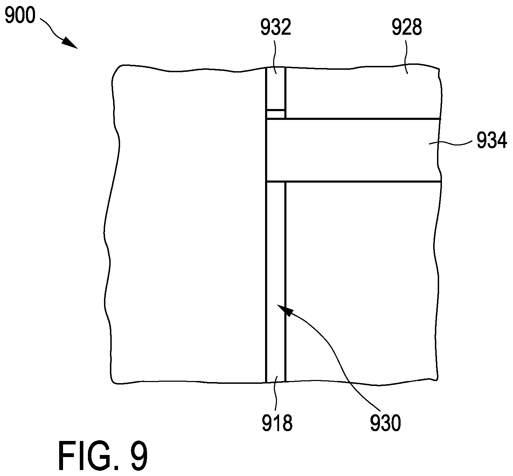

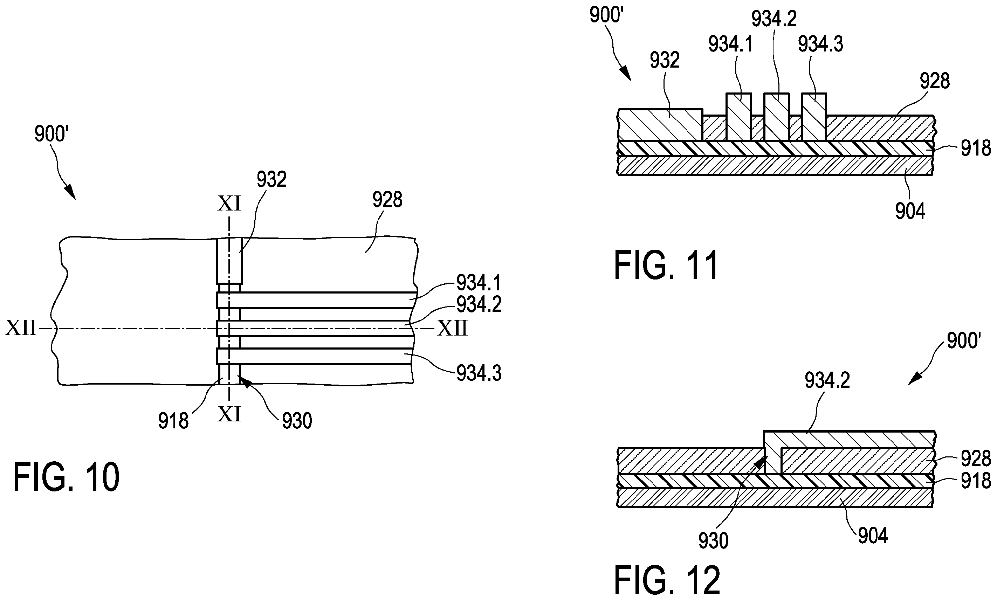

The following description refers to Figs. 9 to 12 in parallel. Figs. 9 to 12 are different views of a semiconductor component 900. A general structure of the semiconductor component 900 is illustrated in Fig. 9, an exemplary implementation of the semiconductor component 900 is shown under the reference label 900' in Figs. 10 to 12. Similar to the embodiment of Figs. 3 and 4, the semiconductor component 900 has a stressor layer 928 on a dielectric layer 918. Also similarly, the stressor layer 928 is patterned and has a stressor trench 930. An injection gate electrode 932 is provided for the injection of charge carriers coming from a charge carrier reservoir (e.g. a doped area). The injection gate electrode is arranged in a section of the stressor trench 930. Furthermore, a confinement gate electrode structure 934 schematically illustrated in Fig. 9 is shown in more detail in Figs 10 to 12. The confinement gate electrode structure 934 may thus be implemented by three confinement gate electrodes 934.1, 934.2 and 934.3 for controlling the creation of accumulation and depletion regions to create an electrostatic confinement potential profile defining a quantum dot within a longitudinal section of the stressor trench 930, which corresponds to the extension of the confinement gate electrode structure 934. The confinement gate electrode group 934 is thus arranged to generate, under application of suitable respective confinement control voltages to the confinement gate electrodes 934.1 to 934.3, a confinement potential profile along the longitudinal direction of the trench 930, which enables a carrier accumulation zone and charge carrier depletion zones to form the quantum dot volume in the confinement layer underneath the trench and between the outer confinement gate electrodes 934.1 and 934.3.

Fig. 11 is a cross-sectional view of the semiconductor component 900' along the vertical dashed line XI-XI in Fig. 10. Fig.12 is a further cross-section view of the semiconductor component 900' along the horizontal dashed line XII-XII in Fig. 10. Figs. 11 and 12 show the confinement gate electrodes 934.1 to 934.3 having an L-shape, wherein a section corresponding to the long L-bar extends on the stressor layer 928 and a section corresponding to the short L-bar extends into the trench 930 down to the dielectric layer 918. The stressor layer 928 is thus patterned to accommodate the sections forming the short L-bar of the confinement gate electrodes 934.1 to 934.3 that extend through the stressor layer 928. Thus, the stressor trench 930 accommodates, in a sequence along its longitudinal direction, the confinement electrode group 934 which extends in a direction perpendicular to its longitudinal direction.

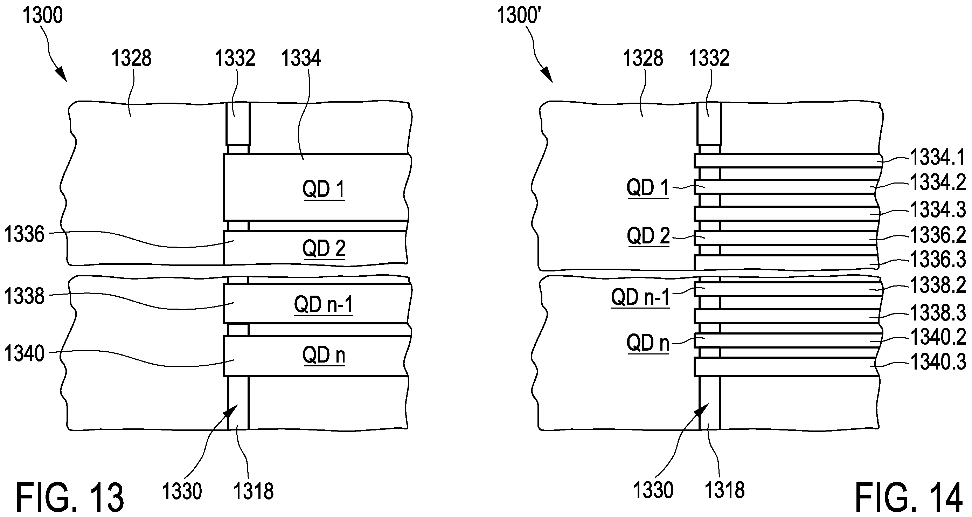

The following description refers to Figs. 13 and 14 in parallel. Figs. 13 and 14 are different plan views of a semiconductor component 1300. A general structure of the semiconductor component 1300 is illustrated in Fig. 13, which is a plan view of the stressor layer 1328 and confinement gate electrode structures 1334, 1336, 1338, and 1340. An exemplary implementation of the semiconductor component 1300 is shown under the reference label 1300' in Fig 14. Fig. 14 is also a plan view, similar to Fig. 13.

The semiconductor component 1300 has a plurality of n quantum dots QD1, QD2, ..., QDn-1, QDn arranged in sequence along the stressor trench 1330. The quantum dots are created using confinement gate electrode groups 1334, 1336, 1338, and 1340. As shown in Fig. 14, these confinement gate electrode groups are each formed by a set of confinement gate electrodes, for instance shown under the reference labels 1334.1, 1334.2, 1334.3 for the confinement gate electrode group 1334. In the present example, neighboring confinement gate electrode groups may be described as sharing one confinement gate electrode, such that the confinement gate electrode groups 1336, 1338, and 1340 have only two further confinement gate electrodes 1336.2 and 1336.3, 1338.2 and 1338.3, and 1340.2 and 1340.3, respectively. Thus, by providing a plurality of the confinement gate electrode groups along the longitudinal trench direction, a corresponding plurality of quantum dot volumes in the confinement layer is formed.

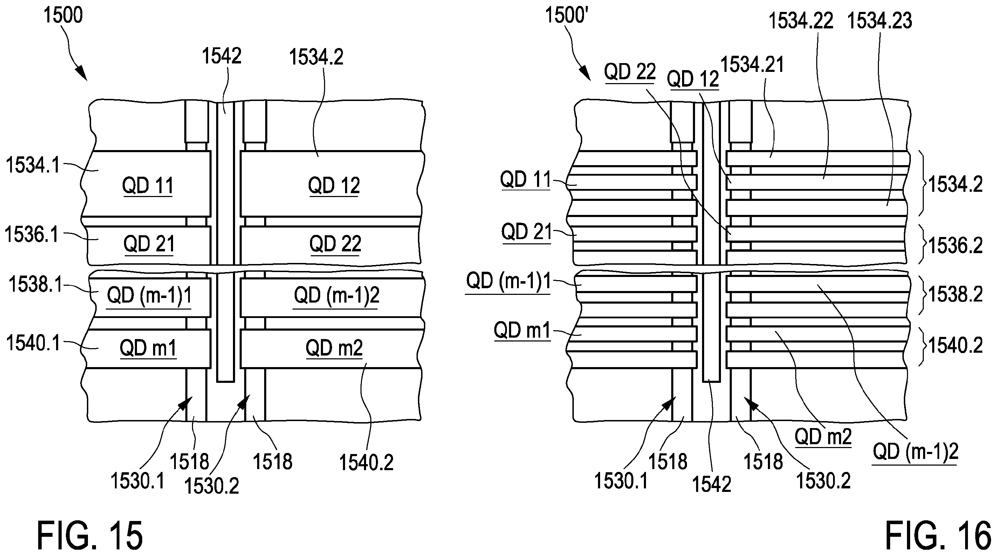

The following description refers to Figs. 15 and 16 in parallel. Figs. 15 and 16 are different plan views of a semiconductor component 1500. A general structure of the semiconductor component 1500 is illustrated in Fig. 15, which is a plan view of the stressor layer 1528, and confinement gate electrode structures 1534, 1536, 1538, and 1540.

The stressor layer 1528 comprises two parallel longitudinal stressor trenches 1530.1 and 1530.2. Each stressor trench has an injection device 1532.1 and 1532.2, respectively. Each stressor trench is further associated with a plurality of m confinement gate electrode groups 1534.1 to 1540.1 and 1534.2 to 1540.2, respectively along its respective longitudinal extension, to allow forming m quantum dots QD11, QD21, ..., QD(m-1)1, QDm1 and QD12, QD22,..., QD(m-1)2, QDm2, respectively, along the longitudinal extension of the stressor trenches 1530.1 and 1530.2. Depending on the number m, more injection devices can be arranged along longitudinal extension of the stressor trenches. A coupling gate electrode 1542 extends between the stressor trenches 1530.1 and 1530.2to allow establishing an interaction between neighboring quantum dots on each side by setting a suitable coupling control voltage. The semiconductor component 1500 thus comprises a matrix arrangement with matrix rows of quantum dots and with matrix columns of quantum dots along a longitudinal extension of the coupling electrode 1542. Two respective quantum dots, such as the quantum dots QD11 and QD12 on opposite sides of the coupling electrode 1542 in the first matrix row house a respective qubit pair. An exemplary implementation of the semiconductor component 1500 is shown under the reference label 1500' in Fig 16. Fig. 16 also is a plan view, similar to Fig. 15. The arrangement of the confinement gate electrode groups, cf. reference labels 1534.2, 1536.2, 1538.2, 1540.2 for those of the right stressor trench 1530.2, corresponds to that described in the context of the previous embodiments. For instance, the confinement gate electrode group comprises three confinement gate electrodes 1534.21, 1534.22, and 1534.23.

The interaction of neighboring QDs can be manifold. A QD used in terms of a readout device is sensitive to even smallest potential changes, single electrons, in the vicinity. Thus, the QD acts as charge sensor. Here, the quantum information (spin state) is transferred to a charge information, before, by loading a neighboring QD exploiting the Pauli spin blockade mechanism. Thus, loading and unloading by applying bias to the confinement gates is another way of QD interaction. Furthermore, interdot tunnel coupling may be used for charge and spin manipulation by tuning the gate voltages.

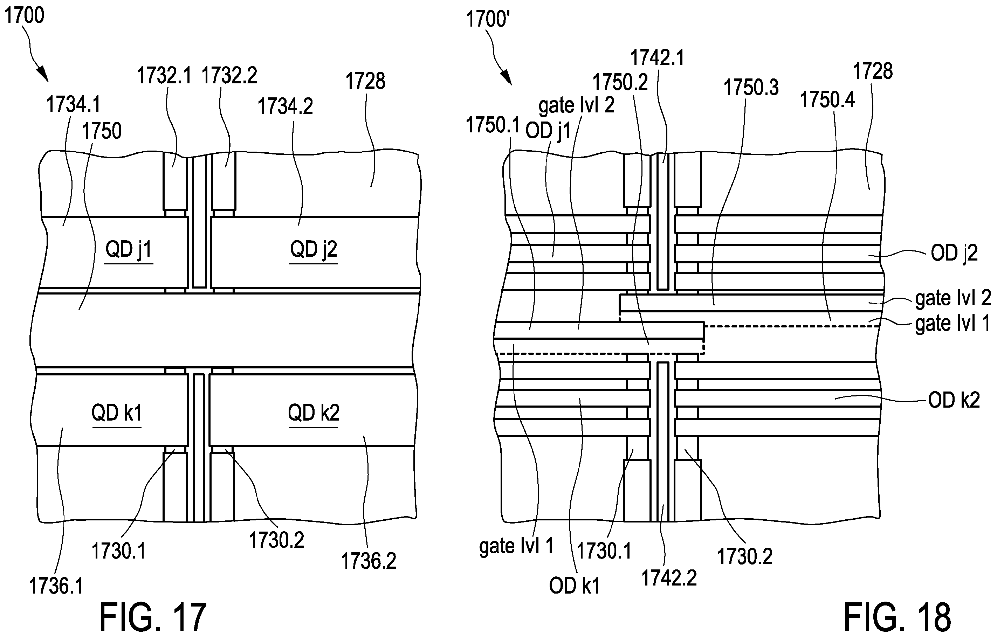

The following description refers to Figs. 17 and 18 in parallel. Figs. 17 and 18 are different plan views of a semiconductor component 1700, which generally has a similar structure as the semiconductor component 1500 of Figs. 15 and 16. A general structure of the semiconductor component 1700 is illustrated in Fig. 17, which is a plan view of the stressor layer 1728, confinement gate electrode structures 1734.1, 1734.2, 1736.1, 1736.2 along stressor trenches 1730.1 and 1730.2. Only two rows j and k and two columns 1 and 2 of quantum dots QD QDj1, QDj2, QDk1, QDk2 are exemplary shown instead of a full matrix for simplification. In comparison to the semiconductor component 1500, the present embodiment of a semiconductor component 1700 additionally includes a shuttling electrode arrangement 1750 between the neighboring matrix rows of quantum dots, for example in Fig. 17 the matrix rows 1734 and 1736. The shuttling electrode arrangement 1750 can be implemented in the form of shuttling electrodes 1750.1 to 1750.4 extending perpendicularly to the longitudinal extension of the stressor trenches between two neighboring matrix rows j and k. The shuttling electrodes 1750.1 to 1750.4 can interconnect, by application of a respective electrostatic shuttling voltage, the qubits of the neighboring matrix rows j and k by interdot tunnel coupling. This way, a transport of the qubits along the longitudinal trench direction may be achieved. The distance of charge carrier transport can be influenced by a desired number of repetitions of the group of shuttling electrodes in the longitudinal direction. In these embodiments, the presence of the stressor layer improves the carrier confinement, thus reduces the effect of perturbations and improves the stability of a quantum state during qubit transport.

The term "accommodate" is used here to mean an embedded or partially embedded arrangement of the shuttling electrodes in the stressor layer, or an arrangement of the shuttling electrodes underneath the stressor layer.

The electrostatic shuttling potential may have a sinusodial shape in the confinement layer. The shuttling electrodes, which are suitably embedded in dielectric material in the exemplary implementation of Fig. 18 are arranged at different distances from the confinement layer, labeled as "gate lvl1" and gate lvl2" in Fig. 18. Seen in a plan view, the shuttling electrodes at different distances from the confinement layer laterally overlap each other. This allows achieving a particularly smooth shuttling potential profile. It is noted that also the QD confinement electrodes may overlap and be arranged in different metal layers separated by an insulator.

The invention is summarized by the appended set of claims.

## Claims

1. A semiconductor component (100), comprising
- a semiconductor substrate (102);
- a semiconductor hetero structure (104) deposited on the semiconductor substrate (102) or above the semiconductor substrate (102) on a buffer layer (108) or on an insulating layer and comprising
- an active layer stack (116) that includes a confinement layer (110) and one or more barrier layers (112) for establishing a quantum confinement of charge carriers (122) to two-dimensions in the confinement layer (110);
- a dielectric layer (118) on the active layer stack (116);
- confinement gate electrodes (120.1, 120.2, 120.3) for receiving a respective electrical confinement control voltage and arranged for applying the respective electrical confinement control voltage to the active layer stack (116) for jointly generating a first electrostatic confinement potential profile component of a total lateral confinement potential profile in the confinement layer (110);
- a stressor layer (328) below, on top or embedded in the dielectric layer (118) and arranged to apply additional, spatially varying lattice strain to the active layer stack (116) in particular to the confinement layer (110), for generating a strain-based second confinement potential component of the total lateral confinement potential profile in the confinement layer (110), wherein the stressor layer (328, 928, 1328, 1728) comprises a stressor recess structure (330, 930, 1330, 1530.1, 1530.2, 1730.1, 1730.2) that defines a one-dimensional strain-induced carrier confinement region in the confinement layer (110) that contributes to or fully achieves a confinement of charge carriers (122) to a lateral region of the one-dimensional stressor recess structure (330, 930, 1330, 1530.1, 1530.2, 1730.1, 1730.2), which corresponds to a lateral extension of the one-dimensional stressor recess structure (330, 930, 1330, 1530.1, 1530.2, 1730.1, 1730.2) that is perpendicular to its longitudinal extension;
- a confinement control unit configured to generate and provide the respective electrical confinement control voltages to the confinement gate electrodes (120.1, 120.2, 120.3); wherein
- the total lateral confinement potential profile thus generated in the confinement layer (110) by the confinement control voltages and by the structured stressor layer (328) limits a localization of the charge carriers (120) to a volume spanning less than two dimensions and creates an energy split between at least two conduction band valleys hosting confined charge carrier spin states.

2. The semiconductor component of claim 1, wherein the active layer stack (116) further comprises a capping layer, on which the dielectric layer (118) is deposited.

3. The semiconductor component of claim 1, wherein the confinement gate electrodes (120.1, 120.2, 120.3) are arranged on the dielectric layer (118).

4. The semiconductor component of any of the preceding claims, wherein the confinement gate electrodes (120.1, 120.2, 120.3) are arranged on the stressor layer (328).

5. The semiconductor component of any of the preceding claims, wherein the stressor layer (928) is patterned to accommodate sections of the confinement gate electrodes 934.1, 934.2 and 934.3) extending through the stressor layer (928).

6. The semiconductor component of any of the preceding claims, wherein the stressor recess structure (930) accommodates a device (932) for injecting charge carriers into the confinement layer (110).

7. The semiconductor component (900') of any of the preceding claims, wherein
- the stressor recess structure (930) accommodates, in a sequence along its longitudinal direction, a confinement electrode group (934.1, 934.2, 934.3) crossing the stressor recess structure (930) in a direction perpendicular to its longitudinal direction, the stressor recess structure takes the form of a longitudinal stressor trench and wherein
- the confinement gate electrode group (934.1, 934.2, 934.3) is arranged to generate, under application of suitable respective confinement control voltages to the confinement gate electrodes (934.1, 934.2, 934.3), a confinement potential profile along the longitudinal direction, which enables a carrier accumulation zone and charge carrier depletion zones to form the volume spanning less than two dimensions as a quantum dot volume in the confinement layer underneath the trench and between outer confinement gate electrodes (934.1, 934.3).

8. The semiconductor component of claim 7, comprising a plurality of the confinement gate electrode groups (934.1, 934.2, 934.3) along the longitudinal trench direction, to form a corresponding plurality of quantum dot volumes in the confinement layer.

9. The semiconductor component of claims 7 or 8, wherein the confinement control unit is configured to generate and provide the confinement control voltages suitably for manipulating a spin state and/or a charge state of a qubit formed by one or more charge carriers within the one or more of the quantum dot volumes.

10. The semiconductor component (1500) of any of claims 7 to 9, comprising two or more parallel longitudinal stressor trenches (1530.1, 1530.2), each having one or more injection devices, and at least one confinement gate electrode group (1534.1, 1536.1, 1538.1, 1540.1; 1534.2, 1536.2, 1538.2, 1540.2) along its longitudinal extension, configured to form a matrix of quantum dot volumes in the confinement layer.

11. The semiconductor component of claim 10, further comprising
- a longitudinal coupling trench in the stressor layer in parallel to as well as between a pair of parallel longitudinal stressor trenches, wherein the longitudinal coupling trench accommodates a coupling electrode (1542) with a longitudinal extension corresponding to that of all confinement gate electrode groups (1534.1, 1536.1, 1538.1, 1540.1; 1534.2, 1536.2, 1538.2, 1540.2), wherein
- the coupling electrode (1542) is configured to establish, upon application of a suitable coupling voltage, an interaction between confined charge carriers of qubit pairs in quantum dots that are arranged mutually opposite on both sides of the coupling electrode (1542).

12. The semiconductor component (1700) of claim 11, comprising a matrix arrangement with matrix rows of quantum dots and with matrix columns of quantum dots (QS11, QD21, QD(m-1)1, QDm1) along a longitudinal extension of the coupling electrode (1742.1, 1742.2)), wherein two respective quantum dots (QD11, QD12) on opposite sides of the coupling electrode (1742.1, 1742.2) in a matrix row house a respective qubit pair, and wherein the stressor layer is further patterned to accommodate a group of shuttling electrodes (1750.1, 1750.2, 1750.3, 1750.4) extending perpendicularly to the longitudinal extension between two neighboring matrix rows, to interconnect, by application of a respective electrostatic shuttling potential, the qubits of the neighboring matrix rows by interdot tunnel coupling.

13. The semiconductor component (1700) of claim 12, wherein the shuttling electrodes (1750.1, 1750.2, 1750.3, 1750.4) are embedded in dielectric material and are arranged at different distances from the confinement layer, and wherein, seen in a plan view, shuttling electrodes (1750.1, 1750.2, 1750.3, 1750.4) overlap each other.

## Patentansprüche

1. Halbleiterbauelement (100), umfassend
ein Halbleitersubstrat (102);
eine Halbleiter-Heterostruktur (104), die auf dem Halbleitersubstrat (102) oder oberhalb des Halbleitersubstrats (102) auf einer Pufferschicht (108) oder auf einer isolierenden Schicht abgeschieden ist und Folgendes umfasst:
einen aktiven Schichtstapel (116), der eine Confinement-Schicht (110) und eine oder mehrere Barriereschichten (112) zur Herstellung eines Quanten-Confinements von Ladungsträgern (122) auf zwei Dimensionen in der Confinement-Schicht (110) umfasst;
eine dielektrische Schicht (118) auf dem aktiven Schichtstapel (116);
Confinement-Gate-Elektroden (120.1, 120.2, 120.3) zum Empfangen einer jeweiligen elektrischen Confinement-Steuerspannung und angeordnet zum Anlegen der jeweiligen elektrischen Confinement-Steuerspannung an den aktiven Schichtstapel (116) zum gemeinsamen Erzeugen einer ersten elektrostatischen Confinementpotentialprofil-Komponente eines gesamten lateralen Confinementpotentialprofils in der Confinement-Schicht (110);
eine Stressorschicht (328) unterhalb, oberhalb oder eingebettet in die dielektrische Schicht (118), die angeordnet ist, den aktiven Schichtstapel (116), insbesondere die Confinement-Schicht (110), mit einer zusätzlichen, räumlich variierenden Gitterverspannung zu beaufschlagen, zum Erzeugen einer verspannungsbasierten zweiten Confinementpotentialkomponente des gesamten lateralen Confinementpotentialprofils in der Confinement-Schicht (110), wobei die Stressorschicht (328, 928, 1328, 1728) eine Stressor-Aussparungsstruktur (330, 930, 1330, 1530.1, 1530.2, 1730.1, 1730.2) umfasst, die einen eindimensionalen verspannungsinduzierten Ladungsträger-Confinementbereich in der Confinement-Schicht (110) definiert, der zu einem Confinement von Ladungsträgern (122) auf einen lateralen Bereich der eindimensionalen Stressor-Aussparungsstruktur (330, 930, 1330, 1530.1, 1530.2, 1730.1, 1730.2) beiträgt oder dieses vollständig bewirkt, welcher einer lateralen Erstreckung der eindimensionalen Stressor-Aussparungsstruktur (330, 930, 1330, 1530.1, 1530.2, 1730.1, 1730.2) entspricht, die senkrecht zu deren longitudinaler Erstreckung ist;
eine Confinement-Steuereinheit, die dazu ausgebildet ist, die jeweiligen elektrischen Confinement-Steuerspannungen zu erzeugen und den Confinement-Gate-Elektroden (120.1, 120.2, 120.3) bereitzustellen; wobei
das so in der Confinement-Schicht (110) durch die Confinement-Steuerspannungen und durch die strukturierte Stressorschicht (328) erzeugte gesamte laterale Confinementpotentialprofil eine Lokalisierung der Ladungsträger (120) auf ein Volumen begrenzt, das sich über weniger als zwei Dimensionen erstreckt, und eine Energieaufspaltung zwischen mindestens zwei Leitungsbandtälern erzeugt, die eingeschlossene Ladungsträger-Spinzustände beherbergen.

2. Halbleiterbauelement nach Anspruch 1, wobei der aktive Schichtstapel (116) ferner eine Deckschicht umfasst, auf welcher die dielektrische Schicht (118) abgeschieden ist.

3. Halbleiterbauelement nach Anspruch 1, wobei die Confinement-Gate-Elektroden (120.1, 120.2, 120.3) auf der dielektrischen Schicht (118) angeordnet sind.

4. Halbleiterbauelement nach einem der vorherigen Ansprüche, wobei die Confinement-Gate-Elektroden (120.1, 120.2, 120.3) auf der Stressorschicht (328) angeordnet sind.

5. Halbleiterbauelement nach einem der vorherigen Ansprüche, wobei die Stressorschicht (928) strukturiert ist, um Abschnitte der Confinement-Gate-Elektroden (934.1, 934.2 934.3), die sich durch die Stressorschicht (928) erstrecken, aufzunehmen.

6. Halbleiterbauelement nach einem der vorherigen Ansprüche, wobei die Stressor-Aussparungsstruktur (930) eine Vorrichtung (932) zum Injizieren von Ladungsträgern in die Confinement-Schicht (110) aufnimmt.

7. Halbleiterbauelement (900') nach einem der vorherigen Ansprüche, wobei
die Stressor-Aussparungsstruktur (930) in einer Sequenz entlang ihrer longitudinalen Richtung eine Confinementelektrodengruppe (934.1, 934.2, 934.3) aufnimmt, die die Stressor-Aussparungsstruktur (930) in einer Richtung senkrecht zu ihrer longitudinalen Richtung kreuzt, wobei die Stressor-Aussparungsstruktur die Form eines longitudinalen Stressorgrabens annimmt, und wobei
die Confinement-Gate-Elektrodengruppe (934.1, 934.2, 934.3) dazu angeordnet ist, unter Anlegen geeigneter jeweiliger Confinement-Steuerspannungen an die Confinement-Gate-Elektroden (934.1, 934.2, 934.3) ein Confinementpotentialprofil entlang der longitudinalen Richtung zu erzeugen, welches ermöglicht, dass eine Ladungsträger-Akkumulationszone und Ladungsträger-Verarmungszonen das Volumen, das sich über weniger als zwei Dimensionen erstreckt, als Quantenpunktvolumen in der Confinement-Schicht unterhalb des Grabens und zwischen äußeren Confinement-Gate-Elektroden (934.1, 934.3) bilden.

8. Halbleiterbauelement nach Anspruch 7, umfassend eine Mehrzahl von Confinementelektrodengruppen (934.1, 934.2, 934.3) entlang der longitudinalen Grabenrichtung, um eine entsprechende Mehrzahl von Quantenpunktvolumina in der Confinement-Schicht zu bilden.

9. Halbleiterbauelement nach Anspruch 7 oder 8, wobei die Confinement-Steuereinheit dazu ausgebildet ist, die Confinement-Steuerspannungen geeignet zu erzeugen und bereitzustellen, um einen Spinzustand und/oder einen Ladungszustand eines Qubits, das durch einen oder mehrere Ladungsträger innerhalb eines oder mehrerer der Quantenpunktvolumina gebildet wird, zu manipulieren.

10. Halbleiterbauelement (1500) nach einem der Ansprüche 7 bis 9, umfassend zwei oder mehr parallele longitudinale Stressorgräben (1530.1, 1530.2), die jeweils eine oder mehrere Injektionsvorrichtungen und mindestens eine Confinementelektrodengruppe (1534.1, 1536.1, 1538.1, 1540.1; 1534.2, 1536.2, 1538.2, 1540.2) entlang ihrer longitudinalen Erstreckung aufweisen, die dazu ausgebildet sind, eine Matrix von Quantenpunktvolumina in der Confinement-Schicht zu bilden.

11. Halbleiterbauelement nach Anspruch 10, ferner umfassend
einen longitudinalen Kopplungsgraben in der Stressorschicht, parallel zu sowie zwischen einem Paar paralleler longitudinaler Stressorgräben, wobei der longitudinale Kopplungsgraben eine Kopplungselektrode (1542) mit einer longitudinalen Erstreckung entsprechend derjenigen aller Confinementelektrodengruppen (1534.1, 1536.1, 1538.1, 1540.1; 1534.2, 1536.2, 1538.2, 1540.2) aufnimmt, wobei
die Kopplungselektrode (1542) dazu ausgebildet ist, bei Anlegen einer geeigneten Kopplungsspannung eine Wechselwirkung zwischen eingeschlossenen Ladungsträgern von Qubit-Paaren in Quantenpunkten herzustellen, die auf beiden Seiten der Kopplungselektrode (1542) gegenseitig gegenüberliegend angeordnet sind.

12. Halbleiterbauelement (1700) nach Anspruch 11, umfassend eine Matrixanordnung mit Matrixzeilen von Quantenpunkten und mit Matrixspalten von Quantenpunkten (QS11, QD21, QD(m-1)1, QDm1) entlang einer longitudinalen Erstreckung der Kopplungselektrode (1742.1, 1742.2), wobei zwei jeweilige Quantenpunkte (QD11, QD12) auf gegenüberliegenden Seiten der Kopplungselektrode (1742.1, 1742.2) in einer Matrixzeile ein jeweiliges Qubit-Paar beherbergen, und
wobei die Stressorschicht ferner strukturiert ist, um eine Gruppe von Shuttling-Elektroden (1750.1, 1750.2, 1750.3, 1750.4) aufzunehmen, die sich senkrecht zur longitudinalen Erstreckung zwischen zwei benachbarten Matrixzeilen erstrecken, um durch Anlegen eines jeweiligen elektrostatischen Shuttling-Potentials die Qubits der benachbarten Matrixzeilen durch Interdot-Tunnelkopplung zu verbinden.

13. Halbleiterbauelement (1700) nach Anspruch 12, wobei die Shuttling-Elektroden (1750.1, 1750.2, 1750.3, 1750.4) in dielektrischem Material eingebettet und in unterschiedlichen Abständen von der Confinement-Schicht angeordnet sind, und wobei, in einer Draufsicht gesehen, sich Shuttling-Elektroden (1750.1, 1750.2, 1750.3, 1750.4) gegenseitig überlappen.

## Revendications

1. Composant semi-conducteur (100), comprenant
un substrat semi-conducteur (102) ;
une hétérostructure semi-conductrice (104) déposée sur le substrat semi-conducteur (102) ou au-dessus du substrat semi-conducteur (102) sur une couche tampon (108) ou sur une couche isolante et comprenant
un empilement de couches actif (116) qui comprend une couche de confinement (110) et une ou plusieurs couches barrières (112) pour établir un confinement quantique de porteurs de charge (122) à deux dimensions dans la couche de confinement (110) ;
une couche diélectrique (118) sur l'empilement de couches actif (116) ;
des électrodes de grille de confinement (120.1, 120.2, 120.3) destinées à recevoir une tension de commande de confinement électrique respective et agencées pour appliquer la tension de commande de confinement électrique respective à l'empilement de couches actif (116) pour générer conjointement une première composante de profil de potentiel de confinement électrostatique d'un profil de potentiel de confinement latéral total dans la couche de confinement (110) ;
une couche de contrainte (328) située en dessous, au-dessus ou intégrée dans la couche diélectrique (118) et agencée pour appliquer une contrainte de réseau spatialement variable supplémentaire à l'empilement de couches actif (116), en particulier à la couche de confinement (110), pour générer une seconde composante de potentiel de confinement basée sur la contrainte du profil de potentiel de confinement latéral total dans la couche de confinement (110), dans lequel la couche de contrainte (328, 928, 1328, 1728) comprend une structure évidée de contrainte (330, 930, 1330, 1530.1, 1530.2, 1730.1, 1730.2) qui définit une région de confinement de porteurs induite par contrainte unidimensionnelle dans la couche de confinement (110) qui contribue à, ou réalise entièrement, un confinement de porteurs de charge (122) dans une région latérale de la structure évidée de contrainte unidimensionnelle (330, 930, 1330, 1530.1, 1530.2, 1730.1, 1730.2), qui correspond à une extension latérale de la structure évidée de contrainte unidimensionnelle (330, 930, 1330, 1530.1, 1530.2, 1730.1, 1730.2) qui est perpendiculaire à son extension longitudinale ;
une unité de commande de confinement configurée pour générer et fournir les tensions de commande de confinement électriques respectives aux électrodes de grille de confinement (120.1, 120.2, 120.3) ; dans lequel
le profil de potentiel de confinement latéral total ainsi généré dans la couche de confinement (110) par les tensions de commande de confinement et par la couche de contrainte structurée (328) limite une localisation des porteurs de charge (120) à un volume s'étendant sur moins de deux dimensions et crée une scission d'énergie entre au moins deux vallées de bande de conduction hébergeant des états de spin de porteurs de charge confinés.

2. Composant semi-conducteur selon la revendication 1, dans lequel l'empilement de couches actif (116) comprend en outre une couche de recouvrement, sur laquelle la couche diélectrique (118) est déposée.

3. Composant semi-conducteur selon la revendication 1, dans lequel les électrodes de grille de confinement (120.1, 120.2, 120.3) sont agencées sur la couche diélectrique (118).

4. Composant semi-conducteur selon l'une quelconque des revendications précédentes, dans lequel les électrodes de grille de confinement (120.1, 120.2, 120.3) sont agencées sur la couche de contrainte (328).

5. Composant semi-conducteur selon l'une quelconque des revendications précédentes, dans lequel la couche de contrainte (928) est structurée pour recevoir des sections des électrodes de grille de confinement 934.1, 934.2 et 934.3 s'étendant à travers la couche de contrainte (928).

6. Composant semi-conducteur selon l'une quelconque des revendications précédentes, dans lequel la structure évidée de contrainte (930) reçoit un dispositif (932) d'injection de porteurs de charge dans la couche de confinement (110).

7. Composant semi-conducteur (900') selon l'une quelconque des revendications précédentes, dans lequel
la structure évidée de contrainte (930) reçoit, en une séquence le long de sa direction longitudinale, un groupe d'électrodes de confinement (934.1, 934.2, 934.3) traversant la structure évidée de contrainte (930) dans une direction perpendiculaire à sa direction longitudinale, la structure évidée de contrainte prenant la forme d'une tranchée de contrainte longitudinale, et dans lequel
le groupe d'électrodes de grille de confinement (934.1, 934.2, 934.3) est agencé pour générer, sous application de tensions de commande de confinement respectives appropriées aux électrodes de grille de confinement (934.1, 934.2, 934.3), un profil de potentiel de confinement le long de la direction longitudinale, qui permet à une zone d'accumulation de porteurs et à des zones de déplétion de porteurs de charge de former le volume s'étendant sur moins de deux dimensions en tant que volume de point quantique dans la couche de confinement sous la tranchée et entre les électrodes de grille de confinement externes (934.1, 934.3).

8. Composant semi-conducteur selon la revendication 7, comprenant une pluralité de groupes d'électrodes de confinement (934.1, 934.2, 934.3) le long de la direction longitudinale de la tranchée, pour former une pluralité correspondante de volumes de points quantiques dans la couche de confinement.

9. Composant semi-conducteur selon les revendications 7 ou 8, dans lequel l'unité de commande de confinement est configurée pour générer et fournir les tensions de commande de confinement de manière appropriée pour manipuler un état de spin et/ou un état de charge d'un qubit formé par un ou plusieurs porteurs de charge à l'intérieur d'un ou plusieurs des volumes de points quantiques.

10. Composant semi-conducteur (1500) selon l'une quelconque des revendications 7 à 9, comprenant deux ou plusieurs tranchées de contrainte longitudinales parallèles (1530.1, 1530.2), chacune ayant un ou plusieurs dispositifs d'injection, et au moins un groupe d'électrodes de confinement (1534.1, 1536.1, 1538.1, 1540.1 ; 1534.2, 1536.2, 1538.2, 1540.2) le long de son extension longitudinale, configuré pour former une matrice de volumes de points quantiques dans la couche de confinement.

11. Composant semi-conducteur selon la revendication 10, comprenant en outre
une tranchée de couplage longitudinale dans la couche de contrainte, parallèle à ainsi qu'entre une paire de tranchées de contrainte longitudinales parallèles, dans lequel la tranchée de couplage longitudinale reçoit une électrode de couplage (1542) présentant une extension longitudinale correspondant à celle de tous les groupes d'électrodes de confinement (1534.1, 1536.1, 1538.1, 1540.1 ; 1534.2, 1536.2, 1538.2, 1540.2), dans lequel
l'électrode de couplage (1542) est configurée pour établir, lors de l'application d'une tension de couplage appropriée, une interaction entre des porteurs de charge confinés de paires de qubits dans des points quantiques qui sont agencés mutuellement à l'opposé l'un de l'autre sur les deux côtés de l'électrode de couplage (1542).

12. Composant semi-conducteur (1700) selon la revendication 11, comprenant un agencement matriciel avec des lignes de matrice de points quantiques et des colonnes de matrice de points quantiques (QS11, QD21, QD(m-1)1, QDm1) le long d'une extension longitudinale de l'électrode de couplage (1742.1, 1742.2), dans lequel deux points quantiques respectifs (QD11, QD12) situés sur des côtés opposés de l'électrode de couplage (1742.1, 1742.2) dans une ligne de matrice hébergent une paire de qubits respective, et
dans lequel la couche de contrainte est en outre structurée pour recevoir un groupe d'électrodes de transfert (1750.1, 1750.2, 1750.3, 1750.4) s'étendant perpendiculairement à l'extension longitudinale entre deux lignes de matrice voisines, pour interconnecter, par application d'un potentiel de transfert électrostatique respectif, les qubits des lignes de matrice voisines par couplage tunnel inter-points.

13. Composant semi-conducteur (1700) selon la revendication 12, dans lequel les électrodes de transfert (1750.1, 1750.2, 1750.3, 1750.4) sont intégrées dans un matériau diélectrique et sont agencées à des distances différentes de la couche de confinement, et dans lequel, vu en vue de dessus, les électrodes de transfert (1750.1, 1750.2, 1750.3, 1750.4) se chevauchent mutuellement.
